# EUROPÄISCHE PATENTSCHRIFT

(11) **EP 1 859 664 B1**
(45) Veröffentlichungstag und Bekanntmachung des Hinweises auf die Patenterteilung: **31.12.2008**
(21) Anmeldenummer: 06818936.4
(22) Anmeldetag: 30.11.2006
(51) Int. Cl.: H05K 13/02

(54) **FÜHRUNGSBAHN FÜR ELEKTRONISCHE BAUELEMENTE**
GUIDE PATH FOR ELECTRONIC COMPONENTS
PISTE DE GUIDAGE POUR COMPOSANTS ELECTRONIQUES

(30) Priorität: 08.12.2005 DE 102005058704
(43) Veröffentlichungstag der Anmeldung: 28.11.2007
(73) Patentinhaber: Multitest elektronische Systeme GmbH, 83026 Rosenheim (DE)
(72) Erfinder: TASSILO, Drögsler, 83253 Rimsting (DE)
(74) Vertreter: Bauer, Friedrich
(86) Internationale Anmeldenummer: PCT/EP2006/011528
(87) Internationale Veröffentlichungsnummer: WO 2007/065599

(56) Entgegenhaltungen:
- DE-A1- 3 909 971
- DE-C1- 19 827 458
- DE-U1- 8 632 512

## Beschreibung

Die Erfindung betrifft eine Führungsbahn für elektronische Bauelemente, mit einem Führungskanal, in dem die Bauelemente an einer die Bauelemente detektierenden Lichtschranke vorbeigeführt werden.

Derartige Führungsbahnen befinden sich beispielsweise in Handhabungsautomaten für elektronische Bauelemente, sog. Handlern.

Handhabungsautomaten dieser Art werden beispielsweise verwendet, um die elektronischen Bauelemente, insbesondere ICs, einer Temperaturkammer oder einer Testvorrichtung zuzuführen, um die elektrischen Eigenschaften und die einwandfreie Funktion der Bauelemente zu testen. In den Führungsbahnen werden die Bauelemente vorzugsweise mittels ihrer eigenen Schwerkraft fortbewegt.

Um das Vorhandensein bzw. Nichtvorhandensein eines elektronischen Bauelements an einer bestimmten Stelle der Führungsbahn zu detektieren, werden üblicherweise Lichtschranken verwendet, wobei sich Sender und Empfänger der Lichtschranke auf gegenüberliegenden Seiten der Führungsbahn befinden. Gelangt ein Bauelement in den Bereich des vom Sender der Lichtschranke ausgesandten Lichtstrahlbündels, werden die Lichtstrahlen unterbrochen und die Empfängerseite verdunkelt. Die Helligkeitsänderung führt zu einer Änderung des Schaltzustandes der Lichtschranke, so dass hieraus erkannt werden kann, wenn sich ein Bauelement im Bereich der Lichtschranke befindet.

Es ist bekannt (siehe z.B. DE 86 32 512 U1), Lichtschranken entweder seitlich neben den Führungsbahnen oder ober- und unterhalb der Führungsbahnen (bzw. davor oder dahinter) anzuordnen. Bei der seitlichen Anordnung liegen die oberen und unteren Hauptflächen des Bauelements parallel zu den Lichtstrahlen, d.h. die Lichtstrahlen fallen senkrecht auf eine seitliche schmale Stirnfläche des Bauelements. Der Vorteil dieser seitlichen Anordnung besteht darin, dass die Führungsbahnen leicht zugänglich sind. Problematisch ist dabei allerdings, dass insbesondere bei sehr dünnen elektronischen Bauelementen die Gefahr besteht, dass die vom Sender der Lichtschranke ausgesandten Lichtstrahlen nicht in ausreichendem Maße unterbrochen werden und einzelne Lichtstrahlen seitlich am Bauelement vorbei ungehindert zum Empfänger gelangen können, so dass nicht immer einwandfrei festgestellt werden kann, ob ein Bauelement im Bereich der Lichtschranke ist oder nicht.

Dieses Problem wird noch dadurch verstärkt, da die Bauelemente innerhalb des Führungskanals ein gewisses Spiel haben müssen, um ungehindert vorwärts gleiten zu können. Da die Dicken der Bauelemente gewisse Toleranzen haben, muss dieses Spiel auch an die maximal zulässige Dicke der Bauelemente angepasst sein. Insbesondere bei sehr steil oder vertikal angeordneten Führungsbahnen können die einzelnen Bauelemente daher unterschiedlich im Führungskanal liegen, was die eindeutige Abdunklung des Lichtschranken-Empfängers erschwert. Dieses Problem wird durch Lichtreflexionen im Führungskanal verstärkt.

Zur Vermeidung der vorgenannten Probleme, die bei seitlicher Lichtschrankenanordnung auftreten, ist es bekannt, zwischen dem Sender und dem Führungskanal einerseits und zwischen dem Führungskanal und dem Empfänger andererseits Blenden mit kleinen Lichtdurchtrittsöffnungen vorzusehen, so dass nur ein feines Lichtstrahlbündel mit geringem Querschnitt durch den Führungskanal hindurch gesandt wird. Der Verkleinerung des Lichtstrahlbündels sind jedoch Grenzen gesetzt, da normale Lichtschranken eine bestimmte Lichtintensität auf der Empfängerseite benötigen, um einwandfrei zu funktionieren. Sehr empfindliche Lichtschranken mit qualitativ hochwertigen Lichtleiterverstärkern und Lichtwellenleitern sind dagegen entsprechend teuer. Weiterhin bereitet die Herstellung von Blenden mit sehr kleinen Lichtdurchtrittsöffnungen mit einem Durchmesser von 0,5 mm und weniger erhöhte technische Schwierigkeiten.

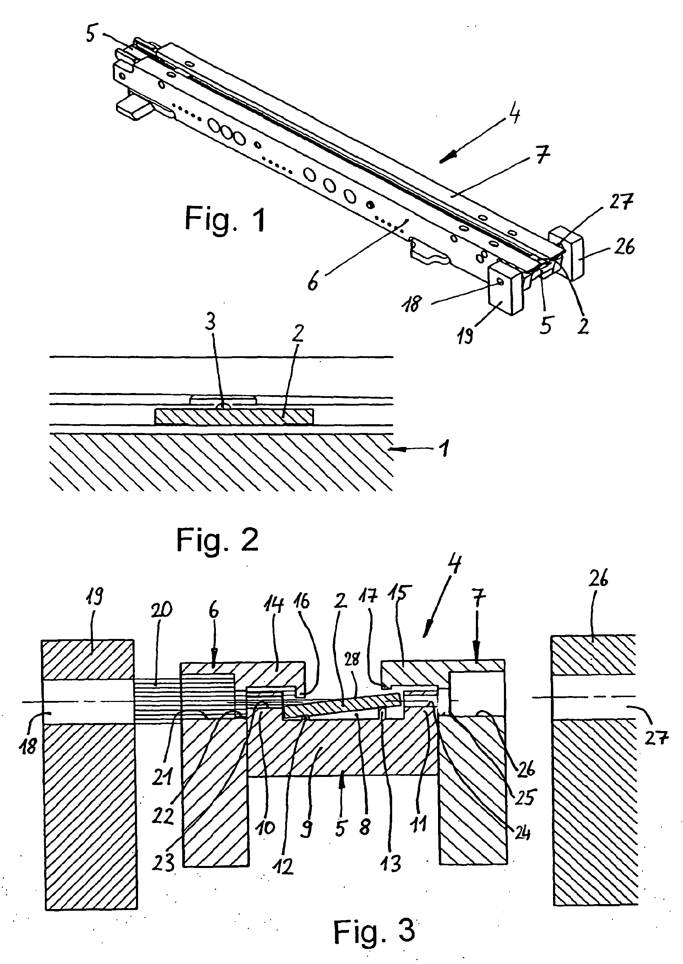

Das Problem, das auftritt, wenn übliche Führungsbahnen für Bauelemente verwendet werden, die extrem dünne Dicken von beispielsweise 0,5 mm und weniger haben, ist in Figur 2 veranschaulicht, die einen Längsschnitt durch eine Führungsbahn 1 gemäß dem Stand der Technik und eines darin geführten elektronischen Bauelements 2 in der Form eines ICs zeigt. Hinter dem Bauelement 2 ist ein Teil einer kreisrunden Blendenöffnung 3 ersichtlich, aus der Lichtstrahlen austreten, die von einem dahinter angeordneten, nicht sichtbaren Senders einer Lichtschranke ausgesandt werden, so dass sie parallel zum Boden des Führungskanals und zum Bauelement 2 zu einer auf der gegenüberliegenden Seite des Führungskanals angeordneten Lichteintrittsöffnung gelangen können, die vor einem nicht dargestellten Empfänger der Lichtschranke liegt.

Wie aus Figur 2 ersichtlich, wird der obere Teil der Blendenöffnung 3 vom Bauelement 2 nicht vollständig abgedeckt, da hierfür die Höhe des Bauelements 2 nicht ausreicht. Oberhalb des Bauelements 2 können somit Lichtstrahlen zum Empfänger der Lichtschranke gelangen, wodurch keine sichere Detektion des Bauelements 2 möglich ist.

Bei einer alternativen Lichtschrankenanordnung gemäß dem Stand der Technik, bei der Sender und Empfänger oberhalb und unterhalb bzw. vor/hinter der Führungsbahn angeordnet sind, so dass die Lichtstrahlen senkrecht auf eine Hauptfläche des Bauelements fallen, treten diese Probleme nicht auf, da die Hauptfläche des Bauelements in jedem Fall groß genug ist, um für eine ausreichende Verdunklung des Lichtschrankenempfängers zu sorgen. Nachteilig einer derartigen alternativen Lichtschrankenanordnung ist jedoch, dass die Führungsbahn wesentlich schlechter zugänglich ist. Aus diesem Grund werden seitlich neben den Führungsbahnen angeordnete Lichtschranken in vielen Fällen bevorzugt.

Der Erfindung liegt die Aufgabe zugrunde, eine Führungsbahn der eingangs genannten Art für elektrische Bauelemente zu schaffen, die bei einer seitlichen Lichtschrankenanordnung ein zuverlässiges Detektieren auch von sehr dünnen Bauelementen gewährleistet.

Diese Aufgabe wird erfindungsgemäß durch eine Führungsbahn mit den Merkmalen des Anspruches 1 gelöst. Vorteilhafte Ausgestaltungen der Erfindung sind in den weiteren Ansprüchen beschrieben.

Die erfindungsgemäße Führungsbahn weist Führungselemente auf, durch welche die Bauelemente zumindest im Bereich der Lichtschranke schräg zur Richtung der Lichtstrahlen geführt sind, so dass das Bauelement eine Schattenfläche erzeugt, die höher als die seitliche Stirnfläche des Bauelements ist.

Durch die erfindungsgemäße Schrägstellung der Bauelemente, d.h. durch das Kippen der Bauelemente um ihre Längsachse, werden nicht mehr oder nicht mehr ausschließlich die seitlichen Stirnflächen der Bauelemente angestrahlt, sondern zumindest auch ein Teil derjenigen Hauptfläche des Bauelements, welche leicht in Richtung des Senders geneigt ist, so dass sich die Schattenfläche auf der Empfängerseite entsprechend vergrößert. Hierdurch kann auf sehr einfache Weise auch bei sehr dünnen Bauelementen gewährleistet werden, dass die dem Bauelement benachbarte Lichteintrittsöffnung auf der Lichtschrankenempfängerseite ausreichend abgedunkelt wird, um ein zuverlässiges Detektieren des Bauelements zu gewährleisten.

Es ist ohne weiteres möglich, die erfindungsgemäße Führungsbahn derart auszubilden, dass nach ihrem Schrägstellungsbereich wieder ein Bereich folgt, in dem das Bauelement parallel zur Lichtschrankenstrahlebene geführt wird.

Vorteilhafterweise beträgt die Schrägstellung der Bauelemente relativ zur Hauptrichtung der Lichtstrahlen 2 bis 30°, insbesondere 2 bis 15°. In bestimmen Fällen können auch noch stärkere Schrägstellungen, zum Beispiel bis zu 90°, zweckmäßig sein.

Gemäß einer vorteilhaften Ausführungsform umfassen die Führungselemente zwei nebeneinander am Boden des Führungskanals angeordnete Längsschienen, die eine unterschiedliche Höhe haben. Hierdurch kann auf einfache Weise die gewünschte Schrägstellung der Bauelemente erreicht werden.

Vorteilhafterweise haben die Längsschienen Auflageflächen für die Bauelemente, die parallel zum Boden des Führungskanals verlaufen, so dass die Bauelemente nur auf den Kanten der Längsstege aufliegen. Die Verringerung der Auflagefläche reduziert Einflüsse von elektrostatischen Aufladungen, wodurch die Bauelemente leichter auf den Längsschienen entlang gleiten und die Gefahr des "Klebenbleibens" verringert wird.

Gemäß einer vorteilhaften Ausführungsform umfassen die Führungselemente zwei den Längsschienen gegenüberliegende und die Bauelemente übergreifende Führungsstege, wobei der der niedrigeren Längsschiene gegenüberliegende Führungssteg weiter in den Führungskanal vorsteht als der der höheren Längsschiene gegenüberliegende Führungssteg, so dass auf beiden Seiten des Führungskanals der Abstand zwischen der Längsschiene und dem zugeordneten Führungssteg zumindest im Wesentlichen gleich ist.

Die Erfindung wird nachfolgend anhand von Zeichnungen beispielhaft näher erläutert. In diesen zeigen:
- Figur 1 :: eine räumliche Darstellung einer erfindungsgemäßen Führungsbahn;
- Figur 2 :: einen Längsschnitt durch eine Führungsbahn gemäß dem Stand der Technik; und
- Figur 3 :: einen Querschnitt durch die Führungsbahn von Figur 1 im Bereich einer Lichtschranke.

Die Figuren 1 und 3 zeigen eine erfindungsgemäße Führungsbahn 4 mit einem mittleren Bahnelement 5 und zwei seitlichen Bahnelementen 6, 7, die zumindest im Wesentlichen symmetrisch zueinander ausgebildet sind und auf gegenüberliegenden Seiten des mittleren Bahnelements 5 angeordnet sind.

Im mittleren Bahnelement 5 befindet sich ein nach oben hin offener Führungskanal 8, der sich in Längsrichtung des mittleren Bahnelements 5 über dessen gesamte Länge erstreckt. Das mittlere Bahnelement 5 weist somit zumindest im Wesentlichen einen U-förmigen Querschnitt mit einem Bodenabschnitt 9 und zwei Seitenabschnitten 10, 11 auf, die über den Bodenabschnitt 9 nach oben vorstehen und den Führungskanal 8 seitlich begrenzen.

Am Boden des Führungskanals 8 sind zwei parallel nebeneinander und mit Abstand zueinander angeordnete Längsschienen 12, 13 vorgesehen, die parallel zur Längsachse der Führungsbahn 4 verlaufen und unterschiedliche Höhen haben, d.h. unterschiedlich weit über den Boden des Führungskanals 8 nach oben vorstehen.

Die Längsschienen 12, 13 dienen als Auflager und Gleitschienen für elektronische Bauelemente 2, so dass diese im Führungskanal 8 entlang gleiten können. Das Entlanggleiten der Bauelemente 2 erfolgt bei einer entsprechenden Schrägstellung oder vertikalen Anordnung der Führungsbahn 1 allein aufgrund ihrer Schwerkraft.

Da die Längsschienen 12, 13 unterschiedliche Höhen haben, sind die Bauelemente 2 nicht parallel zum Boden des Führungskanals 8, sondern schräg zu diesem angeordnet. Im gezeigten Ausführungsbeispiel beträgt der Winkel zwischen der oberen oder unteren Hauptebene des Bauelements 2 und dem Boden des Führungskanals 8 etwa 5°.

Damit die Bauelemente 2 bei einer entsprechend steilen Anordnung der Führungsbahn 4 nicht nach oben aus der Führungsbahn 4 herausfallen können, weisen die seitlichen Bahnelemente 6, 7 Überdeckungsabschnitte 14, 15 auf, die sich über die Seitenabschnitte 10, 11 des mittleren Bahnelements 5 aufeinander zu nach innen über den Führungskanal 8 erstrecken, so dass sie den Führungskanal 8 in seinen Seitenbereichen überdecken.

Die Überdeckungsabschnitte 14, 15 tragen in ihren Endbereichen nach unten vorragende Führungsstege 16, 17, die den Längsschienen 12, 13 in etwa gegenüberliegen, jedoch geringfügig weiter außen als diese angeordnet sind. Der Führungssteg 16, der der niedrigeren Längsschiene 12 gegenüberliegt, erstreckt sich weiter nach unten als der Führungssteg 17, der der höheren Längsschiene 13 gegenüberliegt, so dass der Abstand zwischen der Längsschiene 12 und dem Führungssteg 16 gleich groß ist wie der Abstand zwischen der Längsschiene 13 und dem Führungssteg 17. Dieser Abstand ist so gewählt, dass die zu transportierenden Bauelemente 2 mit einem gewünschten Spiel zwischen den Längsschienen 12, 13, einerseits und den Führungsstegen 16, 17 andererseits aufgenommen werden können und geführt sind. Die seitliche Führung der Bauelemente 2 erfolgt dagegen durch die hochstehenden Seitenabschnitte 10, 11 des mittleren Bahnelements 5.

Um das Vorhandensein bzw. Nichtvorhandensein eines Bauelements 2 an einer bestimmten Stelle der Führungsbahn 4, d.h. in dem in Figur 1 gezeigten Ausführungsbeispiel am rechten Ende der Führungsbahn 4, feststellen zu können, ist an dieser Stelle der Führungsbahn 4 eine seitlich neben der Führungsbahn 4 angeordnete, nicht näher dargestellte Lichtschranke vorgesehen. Die Lichtschranke weist einen Licht imitierenden Sender auf, wobei das Licht über einen Lichtwellenleiter in der Form von Glasfasern in einen Seitenbereich der Führungsbahn 4 geleitet wird. Das Ende des Lichtwellenleiters ist in einer Öffnung 18 einer Haltekonsole 19 befestigt, die sich seitlich neben der Führungsbahn 4 befindet. Der Lichtwellenleiter sendet ein Strahlenbündel 20 mit einem zunächst noch relativ großen Durchmesser aus. Dieses Strahlenbündel 20 tritt in eine äußere seitliche Öffnung 21 mit relativ großem Durchmesser und von dort in eine erste Blendenöffnung 22 mit einem kleineren Durchmesser ein, die sich im seitlichen Bahnelement 6 befinden. Weiterhin ist im nach oben vorstehenden Seitenabschnitt 10 des mittleren Bahnelements 5 eine zweite Blendenöffnung 23 vorgesehen, die zur ersten Blendenöffnung 22 fluchtet und einen nochmals kleineren Durchmesser aufweist, so dass das durch die zweite Blendenöffnung 23 hindurchtretende Lichtstrahlbündel den gewünschten kleinen Durchmesser aufweist.

Die rechte Hälfte der Führungsbahn 4 ist bezüglich der Lichtstrahlöffnungen symmetrisch ausgebildet, d.h. der Seitenabschnitt 11 weist eine zweite Blendenöffnung 24 auf, die zur zweiten Blendenöffnung 23 fluchtet und den gleichen Durchmesser wie diese hat, und das seitliche Bahnelement 7 weist eine der Blendenöffnung 22 entsprechende erste Blendenöffnung 25 und eine der äußeren Öffnung 21 entsprechende äußere seitliche Öffnung 26 auf.

Seitlich neben dem seitlichen Bahnelement 7 befindet sich wiederum eine Haltekonsole 26 mit einer Öffnung 27, die zur Halterung eines nicht näher dargestellten Lichtwellenleiters dient, der zum Empfänger der Lichtschranke führt.

Die beschriebenen Öffnungen sind derart fluchtend zueinander angeordnet, dass Lichtstrahlen, die vom Sender der Lichtschranke, d.h. in Figur 3 von links, ausgesendet werden, durch die einzelnen Öffnungen und den Führungskanal 8 hindurch zum Lichtschrankenempfänger gelangen, wenn sich kein Bauelement 2 in diesem Bereich des Führungskanals 8 befindet.

Befindet sich dagegen ein Bauelement 2 im Bereich zwischen den beiden zweiten Blendenöffnungen 23, 24, werden die Lichtstrahlen durch das Bauelement 2 unterbrochen, so dass die Blendenöffnung 24 im Schatten liegt, wodurch der Lichtschrankenempfänger das Vorhandensein des Bauelements 2 erkennt. Hierbei liegt das Bauelement 2 derart schräg im Führungskanal 8, dass der linke Stirnseitenbereich des Bauelements 2 zumindest teilweise unterhalb der Blendenöffnung 24 liegt, während der rechte Stirnseitenbereich des Bauelements 2 zumindest teilweise oberhalb der Blendenöffnung 24 liegt. Hierdurch wird die obere Hauptfläche 28 des Bauelements 2 schräg angestrahlt, wobei der Winkel zwischen den Lichtstrahlen und der Hauptfläche 28 im gezeigten Ausführungsbeispiel etwa 5° beträgt.

Die Längsschienen 12, 13 weisen obere Stirnflächen auf, die parallel zum Boden des Führungskanals 8 angeordnet sind. Die Bauelemente 2 liegen daher aufgrund ihrer Schrägstellung nur auf jeweils einer Kante der Längsschienen 12, 13 auf, so dass sich eine linien- oder schneidenförmige Auflage für die Bauelemente 2 ergibt. Hierdurch wird der Einfluss elektrostatischer Aufladungen und die Neigung der Bauelemente 2 reduziert, an den Längsschienen 12, 13 kleben zu bleiben.

## Patentansprüche

1. Führungsbahn für elektronische Bauelemente, mit einem Führungskanal (8), in den die Bauelemente (2) an einer die Bauelemente (2) detektierenden Lichtschranke vorbeigeführt werden, die einen seitlich neben der Führungsbahn (4) angeordneten Sender und Empfänger aufweist, so dass die Lichtstrahlen von der Seite der Führungsbahn (4) her in den Führungskanal eingeleitet werden, **dadurch gekennzeichnet, dass** die Führungsbahn (4) Führungselemente aufweist, durch welche die Bauelemente (2) zumindest im Bereich der Lichtschranke schräg zur Richtung der Lichtstrahlen geführt sind, so dass das Bauelement (2) eine Schattenfläche erzeugt, die höher als die seitliche Stirnfläche des Bauelements (2) ist.

2. Führungsbahn nach Anspruch 1, **dadurch gekennzeichnet, dass** die Schrägstellung der Bauelemente (2) relativ zur Hauptrichtung der Lichtstrahlen 2 bis 30° beträgt.

3. Führungsbahn nach Anspruch 1 oder 2, **dadurch gekennzeichnet, dass** die Führungselemente zwei nebeneinander am Boden des Führungskanals (8) angeordnete Längsschienen (12, 13) umfassen, die eine unterschiedliche Höhe haben.

4. Führungsbahn nach Anspruch 3, **dadurch gekennzeichnet, dass** die Längsschienen (12, 13) Auflageflächen für die Bauelemente (2) haben, die parallel zum Boden des Führungskanals (8) verlaufen, so dass die Bauelemente (2) nur auf den Kanten der Längssschiene (12, 13) aufliegen.

5. Führungsbahn nach einem der vorhergehenden Ansprüche, **dadurch gekennzeichnet, dass** die Führungselemente Führungsstege (16, 17) umfassen, wobei der der niedrigeren Längsschiene (12) gegenüberliegende Führungssteg (16) weiter in den Führungskanal (8) vorsteht als der der höheren Längsschiene (13) gegenüberliegende Führungssteg (17), so dass auf beiden Seiten des Führungskanals (8) der Abstand zwischen der Längsschiene (12, 13) und dem zugeordneten Führungssteg (16, 17) zumindest im Wesentlichen gleich ist.

## Claims

1. A guide path for electronic components, with a guide channel (8), in which the components (2) are conducted past a light barrier which detects the components (2), said light barrier having a transmitter and receiver arranged laterally next to the guide path (4), such that the light beams are introduced from the side of the guide path (4) into the guide channel, wherein the guide path (4) has guide elements, by means of which the components (2) are guided, at least in the area of the light barrier, obliquely to the direction of the light beams, such that the component (2) produces a shadow surface which is higher than the side face surface of the component (2).

2. The guide path as claimed in Claim 1, wherein the oblique position of the components (2) relative to the main direction of the light beams amounts to 2 to 30°.

3. The guide path as claimed in Claim 1 or 2, wherein the guide elements comprise two longitudinal rails (12, 13) arranged next to one another on the floor of the guide channel (8), which are of different heights.

4. The guide path as claimed in Claim 3, wherein the longitudinal rails (12, 13) have contact surfaces for the components (2), which run parallel to the floor of the guide channel (8), such that the components (2) come into contact only on the edges of the longitudinal rail (12, 13).

5. The guide path as claimed in any one of the preceding claims, wherein the guide elements comprise guide webs (16, 17), in which the guide web (16) opposite the lower longitudinal rail (12) projects further into the guide channel (8) than the guide web (17) opposite the higher longitudinal rail (13), such that on both sides of the guide channel (8) the distance interval between the longitudinal rail (12, 13) and the guide web (16, 17) allocated to it is at least essentially the same.

## Revendications

1. Voie de guidage pour composants électroniques, comportant un canal de guidage (8) dans lequel les composants (2) sont guidés le long d'une barrière lumineuse qui détecte les composants (2) et qui comprend un émetteur et un récepteur agencés latéralement à côté de la voie de guidage (4), de sorte que les rayons lumineux sont injectés depuis le côté de la voie de guidage (4) jusque dans le canal de guidage, **caractérisée en ce que** la voie de guidage (4) comprend des éléments de guidage par lesquels les composants (2) sont guidés, au moins dans la zone de la barrière lumineuse, en oblique par rapport à la direction des rayons lumineux, de sorte que le composant (2) génère une surface d'ombre qui est plus haute que la surface frontale latérale du composant (2).

2. Voie de guidage selon la revendication 1, **caractérisée en ce que** la position oblique des composants (2) par rapport à la direction principale des rayons lumineux est de 2 à 30°.

3. Voie de guidage selon la revendication 1 ou 2, **caractérisée en ce que** les éléments de guidage comprennent deux rails longitudinaux (12, 13) qui sont agencés l'un à côté de l'autre sur le fond du canal de guidage (8) et qui présentent différentes longueurs.

4. Voie de guidage selon la revendication 3, **caractérisée en ce que** les rails longitudinaux (12, 13) ont des surfaces d'appui pour les composants (2), qui s'étendent parallèlement au fond du canal de guidage (8), de sorte que les composants (2) reposent uniquement sur les arêtes des rails longitudinaux (12, 13).

5. Voie de guidage selon l'une des revendications précédentes, **caractérisée en ce que** les éléments de guidage comprennent des barrettes de guidage (16, 17), la barrette de guidage (16) opposée au rail longitudinal (12) plus bas dépasse dans le canal de guidage (8) plus loin que la barrette de guidage (17) opposée au rail longitudinal plus haut (13), de sorte que sur les deux côtés du canal de guidage (8) la distance entre le rail longitudinal (12, 13) et la barrette de guidage associée (16, 17) est au moins sensiblement la même.
